(19) Europäisches Patentamt
European Patent Office
Office européen des brevets

(11) **EP 2 770 518 A2**

(12) **EUROPEAN PATENT APPLICATION**

(43) Date of publication:
   **27.08.2014 Bulletin 2014/35**

(51) Int Cl.:
   ***H01G 9/20*** (2006.01)

(21) Application number: **13198133.4**

(22) Date of filing: **18.12.2013**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(30) Priority: **22.02.2013 KR 20130019371**

(71) Applicant: **Samsung SDI Co., Ltd.**
   **Yongin-si, Gyeonggi-do (KR)**

(72) Inventors:
   • **Cha, Si-Young**
      **Gyeonggi-do, (KR)**
   • **Eom, Sang-Hyun**
      **Gyeonggi-do, (KR)**

(74) Representative: **Russell, Tim et al**
   **Venner Shipley LLP**
   **200 Aldersgate**
   **London EC1A 4HD (GB)**

(54) **Electrolyte for Dye-Sensitized Solar Cell and Dye-Sensitized Solar Cell Including the Same**

(57)   An electrolyte for a dye-sensitized solar cell comprising a redox derivative; and a solvent mixture in which a nitrile-based compound having a $C_3$-$C_{10}$ linear carbon chain and a sulfoxide-based compound are mixed in a volume ratio of about 1:9 to about 9:1, as well as a dye-sensitized solar cell comprising the same. A dye-sensitized solar cell including the electrolyte may have improved durability and performance such as energy conversion efficiency and light conversion efficiency.

FIG. 1

EP 2 770 518 A2

## Description

This application claims priority to and the benefit of Korean Patent Application No. 10-2013-0019371, filed on February 22, 2013 in the Korean Intellectual Property Office, the disclosure of which is incorporated herein in its entirety by reference.

The following description relates to electrolytes for dye-sensitized solar cells and dye-sensitized solar cells including the same.

A dye-sensitized solar cell is an electrochemical solar cell that uses an oxide semiconductor electrode including photosensitive dye molecules capable of producing electron-hole pairs by absorbing visible light, and titanium oxide that transfers produced electrons. The dye-sensitized solar cell includes a photocathode including a semiconductor oxide nanoparticle layer where dye is adsorbed, a counter electrode including a platinum catalyst, and an electrolyte including redox ion pairs.

Among the components described above, the electrolyte is a core component that determines durability and performance of the solar cell such as fill factor efficiency (FF), energy conversion efficiency, and light conversion efficiency (Eff).

A comparable dye-sensitized solar cell primarily uses a liquid electrolyte of a low viscosity volatile organic solvent.

However, although the liquid electrolyte of the low viscosity volatile organic solvent has excellent efficiency due to excellent ion conductivity, a volatilization and a leakage may easily occur, thereby decreasing the durability, the energy conversion efficiency, and the light conversion efficiency of a dye-sensitized solar cell.

Accordingly, to reduce the volatilization and the leakage of the electrolyte of the dye-sensitized solar cell, an electrolyte including a solvent having suitable properties such as capable of easily dissolving compounds of the electrolyte and a sufficient boiling point, and a dye-sensitized solar cell including the electrolyte are desired.

One or more aspects of embodiments of the present invention are directed toward electrolytes for dye-sensitized solar cells having improved durability and performance such as energy conversion efficiency and light conversion efficiency.

One or more aspects of embodiments of the present invention are directed toward dye-sensitized solar cells including the electrolytes.

Additional aspects will be set forth in part in the description which follows and, in part, will be apparent from the description, or may be learned by practice of the presented embodiments.

According to a first aspect of the present invention is provided an electrolyte for a dye-sensitized solar cell comprising a redox derivative; and a solvent mixture in which a nitrile-based compound having a $C_3$-$C_{10}$ linear carbon chain and a sulfoxide-based compound are mixed in a volume ratio of about 1:9 to about 9:1.

According to one or more embodiments of the present invention, the nitrile-based compound has an unsubstituted $C_3$-$C_{10}$ linear carbon chain. For example, the nitrile-based compound may be one selected from the group consisting of butyronitrile (butanenitrile), valeronitrile (pentanenitrile), hexanenitrile, and heptanenitrile.

According to one or more embodiments of the present invention, the sulfoxide-based compound may be one selected from the group consisting of dimethyl sulfoxide, methyl sulfoxide, and ethyl methyl sulfoxide.

A viscosity of the solvent mixture at 25°C may be about 0.80 cP to about 1.50 cP.

A dielectric constant of the solvent mixture at 25°C may be about 15 to about 35.

According to one or more embodiments of the present invention, the solvent mixture may further include an auxiliary solvent having a boiling point of 95°C or greater.

The auxiliary solvent may include at least one of an amide-based compound, a nitrile-based compound having an unsubstituted $C_1$-$C_3$ linear carbon chain, and a nitrogen-containing heterocyclic compound having a 6-membered ring structure.

The auxiliary solvent may include at least one selected from the group consisting of formamide, dimethyl acetamide, dimethylformamide, N-methylformamide, diethyl formamide, N, N-dimethyl ethanamide, acetonitrile, propionitrile, pyridine, and 4-tert-butylpyridine (4-TBP).

An amount of the auxiliary solvent may be less than 10 volume parts based on a total of 100 volume parts of the electrolyte.

The redox derivative may provide an $I^-/I_3^-$ redox pair.

According to a second aspect of the present invention is provided a dye-sensitized solar cell comprising:

a first electrode;
a light absorbing layer formed on a surface of the first electrode;
a second electrode disposed opposite to the first electrode where the light absorbing layer is formed on; and the electrolyte of any one of the embodiments described above interposed between the first electrode and the second electrode.

These and/or other aspects will become apparent and more readily appreciated from the following description of the embodiments, taken in conjunction with the accompanying drawings of which:

FIG. 1 schematically illustrates a basic principle of operation of a general dye-sensitized solar cell.

FIG. 2 is a graph showing electrochemical impedance spectroscopy (EIS) analyses of the dye-sensitized solar cells manufactured according to Example 3, and Comparative Examples 2 and 4. The x-axis is Z' (Ohm). The y-axis is -Z" (Ohm).

FIG. 3 is a graph showing normalized efficiency properties of the dye-sensitized solar cells manufactured in Examples 3 and 4, and Comparative Examples 1, 2, and 5 to 7 measured according to time. The x-axis is Time (hr). The y-axis is nor. Eff. (%).

FIG. 4 schematically illustrates a structure of a dye-sensitized solar cell according to an embodiment of the present invention.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

Hereinafter, an electrolyte for a dye-sensitized solar cell and a dye-sensitized solar cell including the electrolyte, according to an embodiment of the present invention, will be described in more detail. It should be understood that the exemplary embodiments described herein should be considered in a descriptive sense only and not for purposes of limitation. The present invention is only defined by the scope of the claims below and equivalents thereof.

According to a first aspect of the present invention is provided an electrolyte for a dye-sensitized solar cell comprising a redox derivative; and a solvent mixture in which a nitrile-based compound having a $C_3$-$C_{10}$ linear carbon chain and a sulfoxide-based compound are mixed in a volume ratio of about 1:9 to about 9:1.

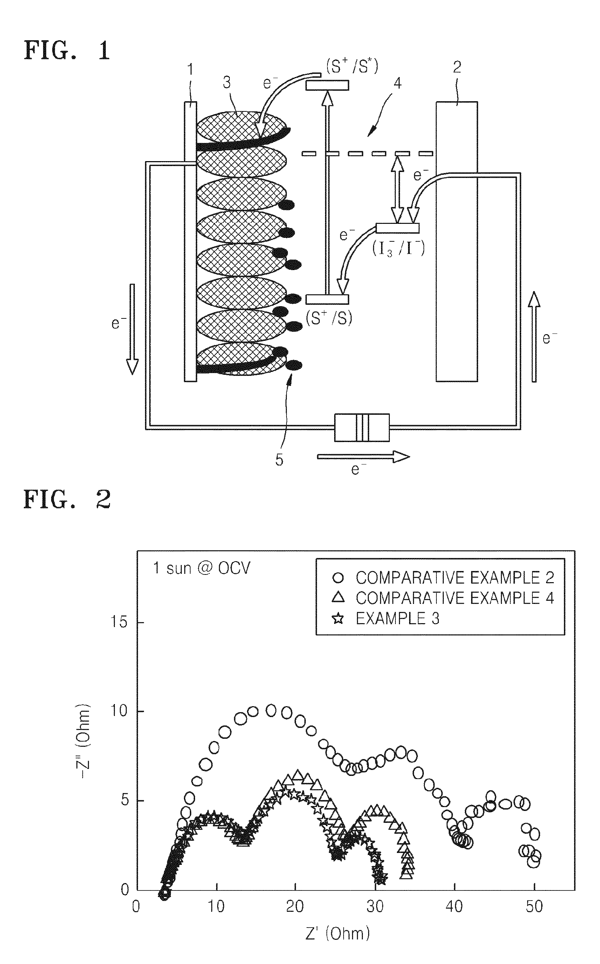

FIG. 1 schematically illustrates a basic principle of operation of a dye-sensitized solar cell.

Referring to FIG. 1, when a dye 5 absorbs sunlight, the dye 5 transfers an electron from a ground state to an excited state to produce an electron-hole pair, the electrons in an excited state are injected into a conductive band of a particle interface of a porous film 3, the injected electrons are transferred to a first electrode 1, and then to a second electrode 2 via an external circuit. On the other hand, a dye that was oxidized due to the transition of electrons is reduced by iodide ions ($I^-$) of a redox couple in an electrolyte 4, and the oxidized iodide ions ($I^{3-}$) are reduced by electrons that reached an interface of the second electrode 2 to achieve a charge neutrality, thereby driving a battery.

Also, the electrolyte 4 included in the dye-sensitized solar cell plays a role of receiving electrons from a counter electrode and transferring the electrons to the dye 5 by a redox reaction of $I^-$/$I^{3-}$.

The durability and performance such as fill factor efficiency (FF), energy conversion efficiency, and light conversion efficiency (R) of the dye-sensitized solar cell may be dependent on physical or chemical properties of an electrolyte for a dye-sensitized solar cell, and a single solvent is generally used as the electrolyte for the dye-sensitized solar cell.

However, when a low viscosity volatile organic solvent is used as an electrolyte solvent, durability of a solar cell may decrease due to leakage and volatilization of the electrolyte solvent. Also, when a high viscosity organic solvent having a high boiling point is used, internal resistance increases substantially due to low ion conductivity of the high viscosity organic solvent, and the efficiency of the solar cell may decrease, compared to when the low viscosity volatile organic solvent is used.

According to embodiments of the present invention, an electrolyte for a dye-sensitized solar cell includes a solvent mixture in which a nitrile-based compound having a $C_3$-$C_{10}$ linear carbon chain and a sulfoxide-based compound are mixed in a volume ratio of about 1:9 to about 9:1. In one embodiment, the volume ratio may be about 2:8 to about 9:1. In another embodiment, the volume ratio may be about 3:7 to about 9:1. The volume ratio changes the properties of the solvent; hence, changing the dielectric constant and the viscosity to improve durability and efficiencies of the dye-sensitized solar cell such as fill factor efficiency (FF), energy conversion efficiency, and light conversion efficiency (R).

The solvent mixture may be a mixture of the nitrile-based compound having a $C_3$-$C_{10}$ linear carbon chain and the sulfoxide-based compound in a volume ratio of about 9:1 to about 5:5.

In one embodiment, the solvent mixture has the nitrile-based compound having a $C_3$-$C_{10}$ linear carbon chain as a primary solvent and the sulfoxide-based compound as a secondary solvent to further improve efficiencies of the dye-sensitized solar cell such as the fill factor efficiency (FF), the energy conversion efficiency, and the light conversion efficiency (R).

The nitrile-based compound may be one selected from the group consisting of butyronitrile, valeronitrile, hexanenitrile, and heptanenitrile. In one embodiment, the nitrile-based compound is valeronitrile.

The sulfoxide-based compound may be one selected from the group consisting of dimethyl sulfoxide, methyl sulfoxide, and ethyl methyl sulfoxide. In one embodiment, the sulfoxide-based compound may be dimethyl sulfoxide.

The solvent mixture may include a solvent mixture in which the valeronitrile of the nitrile-based compound and the dimethyl sulfoxide of the sulfoxide-based compound are respectively mixed in a volume ratio of about 1:9 to about 9:1. In one embodiment, the volume ratio may be about 2:8 to about 9:1. In another embodiment, the volume ratio may be about 3:7 to about 9:1. Such a solvent mixture facilitates movement of electrons from the counter electrode to the dye, compared to a conventional electrolyte material, thereby improving the efficiencies of the dye-sensitized solar cell such as the fill factor efficiency (FF), the energy conversion efficiency, and the light conversion efficiency (R).

Furthermore, the durability of the dye-sensitized solar cell may be improved.

The viscosity of the solvent mixture at a temperature of 25°C may be about 0.80 cP to about 1.50 cP. In one embodiment, the viscosity of the solvent mixture at a temperature of 25°C is about 0.85 cP to about 1.50 cP, and in another embodiment, is about 0.90 cP to about 1.50 cP.

The dielectric constant of the solvent mixture at a temperature of 25°C may be about 15 to about 35. In one embodiment, the dielectric constant of the solvent mixture at a temperature of 25°C is about 15 to about 30.

In one embodiment, when the viscosity and the dielectric constant of the solvent mixture are within the ranges above, the efficiencies and the durability of the electrolyte are improved.

An auxiliary solvent having a boiling point of 95°C or greater may be further included in the solvent mixture. The auxiliary solvent is added in a small amount and performs a supplementary role of improving efficiencies and durability of the electrolyte.

The auxiliary solvent may include at least one of an amide-based compound, a nitrile-based compound having an unsubstituted $C_1$-$C_3$ linear carbon chain and a nitrogen-containing heterocyclic compound having a 6-membered ring structure.

The amide-based compound may be formamide, N-methylformamide (NMF), dimethylformamide, diethylformamide, dimethyl acetamide, N, N-dimethyl ethanamide, or the like.

The nitrile-based compound having an unsubstituted $C_1$-$C_3$ linear carbon chain may be acetonitrile, propionitrile, or the like.

The nitrogen-containing heterocyclic compound having a 6-membered ring structure may be a substituted or unsubstituted pyridine derivative or the like. The pyridine derivative may be, for example, pyridine or 4-tert-butylpyridine (4-TBP).

The auxiliary solvent may be at least one selected from the group consisting of dimethyl acetamide, dimethylformamide, N-methylformamide (NMF), propionitrile, and pyridine.

The amount of the auxiliary solvent may be less than 10 volume parts based on a total of 100 volume parts of the electrolyte. In one embodiment, when the amount of the auxiliary solvent is within the range above, the properties of the electrolyte such as voltage ($V_{oc}$) and current density ($J_{sc}$) are improved.

The redox derivative may provide an $I^-/I_3^-$ redox pair. The redox pair may exist in a concentration of, for example, about 0.1 M to about 1.5 M of the solvent mixture. The $I^-$ and $I_3^-$ ions may be produced from iodide salts and/or iodide compounds and the $I^-$ and $I_3^-$ ions coexist and undergo a reversible reaction.

Non-limiting examples of the iodide salts and/or iodide compounds may include at least one selected from the group consisting of lithium iodide, sodium iodide, potassium iodide, magnesium iodide, copper iodide, silicon iodide, manganese iodide, barium iodide, molybdenum iodide, calcium iodide, iron iodide, cesium iodide, zinc iodide, mercury iodide, ammonium iodide, methyl iodide, methylene iodide, ethyl iodide, ethylene iodide, isopropyl iodide, isobutyl iodide, benzyl iodide, benzoyl iodide, allyl iodide, imidazolium iodide, 1-propyl-3-methyl imidazolium iodide, and 1-butyl-3-methyl imidazolium iodide.

The amount of the iodide salt may be about 150 parts by weight to about 3,000 parts by weight based on 100 parts by weight of iodide ($I_2$), and in one embodiment, when the amount of the iodide salt is within the range above, a redox reaction occurs well, and a flow of the electrons is maintained, thereby increasing an electric current.

According to a further aspect of the present invention is provided a dye-sensitized solar cell comprising a first electrode; a light absorbing layer formed on a side of the first electrode; a second electrode disposed to face the side of the first electrode where the light absorbing layer is formed on; and the above-described electrolyte between the first electrode and the second electrode.

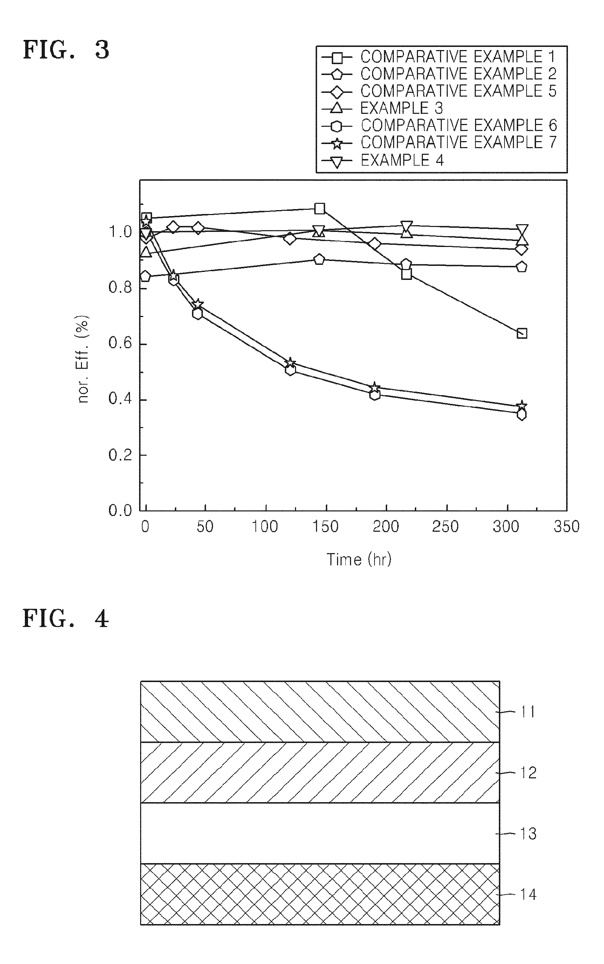

FIG. 4 schematically illustrates a structure of a dye-sensitized solar cell according to an embodiment of the present invention.

The dye-sensitized solar cell includes a first electrode 11, a light absorbing layer 12, an electrolyte 13, and a second electrode 14. The light absorbing layer 12 may include semiconductor particles and dye molecules. Also, the first electrode 11 and the light absorbing layer 12 combined are referred to as a semiconductor electrode.

A transparent substrate is used in the first electrode 11, and any transparent substrate may be used as long as external light may penetrate through the transparent substrate. The transparent substrate may be glass or plastic material. Examples of the plastic material include polyethylene terephthalate (PET), polyethylene naphthalate (PEN), polycarbonate (PC), polypropylene (PP), polyimide (PI), tri-acetyl cellulose (TAC), or a copolymer thereof.

Also, the transparent substrate may be doped with a material selected from the group consisting of titanium (Ti), indium (In), germanium (Ge), and aluminum (Al).

A conductive layer may be formed on the transparent substrate.

The conductive layer may include a conductive metal oxide selected from the group consisting of indium tin oxide (ITO), fluorine-doped tin oxide (FTO), ZnO-($Ga_2O_3$ or $AlO_3$), tin-based oxide, $In_2O_3$, ZnO, antimony-doped tin oxide (ATO), indium zinc oxide (IZO), aluminum-doped zinc oxide (AZO), gallium-doped zinc oxide (GZO), $TiO_2$ doped with conductive impurities, and a mixture thereof. For example, $SnO_2$ having excellent conductivity, transparency, and heat resistance may be used; a comparatively less expensive ITO may be used alone; or a composite layer including ITO and a layer of other bimetallic oxides may be used to reduce resistance after a heat treatment.

The conductive layer may be a single film of the conductive metal oxide or a laminated film.

A porous film, including semiconductor particles, is formed on the first electrode 11 and the light absorbing layer 12 including photo-sensitized dyes is formed on a surface of the porous film.

The porous film has very fine nanopores and the pores are uniformly distributed through the porous film, and includes semiconductor fine particles with a uniform average diameter.

In addition to a single body semiconductor of silicon, a compound semiconductor or a compound having a Perovskite structure may be used as the semiconductor particles. With regard to the semiconductor, in one embodiment, an n-type semiconductor is used, which provides an anode current when conduction band electrons become carriers during an excitation light, and as a compound semiconductor, a metal oxide selected from the group consisting of Ti, zirconium (Zr), strontium (Sr), zinc (Zn), indium (In), lanthanum (La), vanadium (V), molybdenum (Mo), tungsten (W), tin (Sn), niobium (Nb), magnesium (Mg), aluminum (Al), yttrium (Y), scandium (Sc), samarium (Sm), gallium (Ga), indium (In), and TiSr may be used. In one embodiment, the compound semiconductor may be $TiO_2$, $SnO_2$, ZnO, $WO_3$, $Nb_2O_5$, $TiSrO_3$, or a combination thereof, and in another embodiment, the compound semiconductor may use anatase-type $TiO_2$. However, types of the semiconductor are not limited thereto, and the compounds above may be used alone or as a mixture of two or more compounds. A surface area of the semiconductor particles may be enlarged for dyes adsorbed on the surface to absorb more light, and for this, a diameter of the semiconductor particles may be about 20 nm or less.

The porous film may be manufactured using a suitable method of manufacturing a porous film. In one embodiment, a heat treatment is not needed, and the porous film may be manufactured by a mechanical necking treatment capable of adjusting film density by suitably adjusting conditions of the mechanical necking treatment, but the method is not limited thereto.

On a surface of the porous film, dyes that can produce excited electrons by absorbing external light are adsorbed.

Any dyes suitable for a dye-sensitized solar cell may be used. In one embodiment, a ruthenium-based or an organic-based dyes are used. The ruthenium-based dyes may include, for example, an N719 dye [cis-bis(isothiocyanato)bis(2,2'-bipyridyl-4,4'-dicarboxylato)-ruthenium(II)-bis tetrabutylammonium]) or an $N_3$ dye [cis-bis(isothiocyanato)bis(2,2'-bipyridyl-4,4'-dicarboxylato)-ruthenium(II)]. The organic-based dyes may include, for example, (2-Cyano-3-[5'''-(9-Ethyl-9H-carbazol-3-yl)-3',3'',3''',4-tetra-n-hexyl-[2,2',5',2'',5'',2''']-quaterthiophenyl-5-yl]acrylic acid (MK-2)), (2-Cyano-3-{5'-[1-cyano-2-(1,1,6,6-tetramethyl-10-oxo-2,3,5,6-tetrahydro-1H,4H,10H-11-oxa-3a-aza-benzo[de]anthracen-9-yl)-vinyl]-[2,2']bithiophenyl-5-yl}-acrylic acid (NKX-2883)), or (3-{5-[N,N-bis(9,9-dimethylfluorene-2-yl)phenyl]-2,2-bisthiophene-5-yl}-2-cyano-acrylic acid (JK-2)), but they are not limited thereto.

In addition to the ruthenium-based dyes, xanthine-based dyes such as rhodamine B, rose bengal, eosin, and erythrosine; cyanine-based dyes such as quinocyanine and cryptocyanine; alkaline dyes such as phenosafranine, Capri blue, thiosine, and methylene blue; porphyrin-based compounds such as chlorophyll, zinc porphyrin, and magnesium porphyrin; other azo dyes; complex compounds such as phthalocyanine compound and Ru tris(bipyridyl); anthraquinone-based dyes; and polycyclic quinone-based dyes may be used. The dyes may be used alone or as a mixture of two or more dyes.

Also, the light absorbing layer 12 may have a thickness of about 15$\mu$m or less, and in one embodiment, a thickness of about 1$\mu$m to about 15$\mu$m. In one embodiment, when the thickness of the light absorbing layer 12 is greater than about 15$\mu$m, a series resistance increases due to a structural reason, and an increase in the series resistance leads to a decrease in a conversion efficiency. By having the thickness of the light absorbing layer of about 15$\mu$m or less, the series resistance may be maintained at a low level while maintaining the functions of the light absorbing layer 12, thereby preventing a decrease in the conversion efficiency.

The electrolyte 13 between the first electrode 11 and the second electrode 14 is as described above.

The second electrode 14 (a counter electrode) is disposed opposite to the first electrode 11 where the light absorbing layer 12 is formed.

The second electrode 14 may include any conductive material, and even an insulating material may be used as long as a conductive layer is provided on a surface disposed opposite to the semiconductor electrode. Here, an electrochemically stable material may be used as a second electrode, and in some embodiments, the electrochemically stable material may be platinum, gold, carbon, or the like. Also, the surface disposed opposite to the semiconductor electrode for improving catalyst effects of a redox may have a minute structure having an increasing surface area, and in one embodiment, when platinum is used, the platinum may be platinum black, and when carbon is used, the carbon may be porous. The platinum black may be formed by anodization, a chloroplatinic acid treatment, or the like, and the porous carbon may be formed by sintering carbon particles or by calcining organic polymers or the like.

A method of manufacturing a solar cell having the structure described above is known in the art, and is sufficiently understandable by one of ordinary skill in the art. Hence, the method of manufacturing the solar cell will be omitted in the present specification.

Hereinafter, Examples and Comparative Examples of the present invention will be described in order to illustrate the invention.

[Example]

(Preparing an electrolyte for a dye-sensitized solar cell)

**Preparation Example 1**

An electrolyte was prepared by adding a mixture of 1.0 M of 1-butyl-3-methylimidazolium iodide and 0.1 M of iodine to a solvent mixture where valeronitrile and dimethyl sulfoxide were mixed in a volume ratio of 9:1. All reagents used in the process above were purchased from Aldrich Co., and all the reagents were used without additional purification.

**Preparation Example 2**

An electrolyte was prepared in the same manner as in Preparation Example 1, except for using a solvent mixture where valeronitrile and dimethyl sulfoxide were mixed in a volume ratio of 8:2 instead of a solvent mixture where valeronitrile and dimethyl sulfoxide were mixed in a volume ratio of 9:1. All reagents used in the process above were purchased from Aldrich Co., and all the reagents were used without additional purification.

**Preparation Example**

An electrolyte was prepared in the same manner as in Preparation Example 1, except for using a solvent mixture where valeronitrile and dimethyl sulfoxide were mixed in a volume ratio of 7:3 instead of a solvent mixture where valeronitrile and dimethyl sulfoxide were mixed in a volume ratio of 9:1. All reagents used in the process above were purchased from Aldrich Co., and all the reagents were used without additional purification.

**Preparation Example 4**

An electrolyte was prepared in the same manner as in Preparation Example 1, except for using a solvent mixture where valeronitrile, dimethyl sulfoxide, and dimethyl acetamide as an auxiliary solvent were mixed in a volume ratio of 7:2:1, respectively, instead of a solvent mixture where valeronitrile and dimethyl sulfoxide were mixed in a volume ratio of 9:1. All reagents used in the process above were purchased from Aldrich Co., and all the reagents were used without additional purification.

**Preparation Example 5**

An electrolyte was prepared in the same manner as in Preparation Example 1, except for using a solvent mixture where valeronitrile, dimethyl sulfoxide, and dimethylformamide as an auxiliary solvent were mixed in a volume ratio of 7:2:1, respectively, instead of a solvent mixture where valeronitrile and dimethyl sulfoxide were mixed in a volume ratio of 9:1. All reagents used in the process above were purchased from Aldrich Co., and all the reagents were used without additional purification.

**Preparation Example 6**

An electrolyte was prepared in the same manner as in Preparation Example 1, except for using a solvent mixture where valeronitrile, dimethyl sulfoxide, and N-methylformamide (NMF) as an auxiliary solvent were mixed in a volume ratio of 7:2:1, respectively, instead of a solvent mixture where valeronitrile and dimethyl sulfoxide were mixed in a volume ratio of 9:1. All reagents used in the process above were purchased from Aldrich Co., and all the reagents were used without additional purification.

**Preparation Example 7**

An electrolyte was prepared in the same manner as in Preparation Example 1, except for using a solvent mixture where valeronitrile, dimethyl sulfoxide, and propionitrile as an auxiliary solvent were mixed in a volume ratio of 7:2:1, respectively, instead of a solvent mixture where valeronitrile and dimethyl sulfoxide were mixed in a volume ratio of 9:1. All reagents used in the process above were purchased from Aldrich Co., and all the reagents were used without additional purification.

**Preparation Example 8**

An electrolyte was prepared in the same manner as in Preparation Example 1, except for using a solvent mixture where valeronitrile, dimethyl sulfoxide, and pyridine as an auxiliary solvent were mixed in a volume ratio of 7:2:1, respectively, instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 1**

An electrolyte was prepared in the same manner as in Preparation Example 1, except for using an acetonitrile solvent instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 2**

An electrolyte was prepared in the same manner as in Preparation Example 1, except for using an N-methyl pyrrolidone (NMP) solvent instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 3**

An electrolyte was prepared in the same manner as in Preparation Example 1, except for using a valeronitrile solvent instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 4**

An electrolyte was prepared in the same manner as in Preparation Example 1, except for using a solvent mixture where valeronitrile and propylene carbonate (PC) were mixed in a volume ratio of 7:3 instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 5**

An electrolyte was prepared in the same manner as in Preparation Example 1, except for using a 3-methoxy propionitrile solvent instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 6**

An electrolyte was prepared in the same manner as in Preparation Example 1, except for using a solvent mixture where 3-methoxy propionitrile and dimethyl sulfoxide were mixed in a volume ratio of 7:3 instead of a solvent mixture where valeronitrile and dimethyl sulfoxide were mixed in a volume ratio of 9:1. All reagents used in the process above were purchased from Aldrich Co., and all the reagents were used without additional purification.

**Comparative Preparation Example 7**

An electrolyte was prepared in the same manner as in Preparation Example 1, except for using a solvent mixture where 3-methoxy propionitrile, dimethyl sulfoxide, and dimethyl acetamide as an auxiliary solvent were mixed in a volume ratio of 7:2:1, respectively, instead of a solvent mixture where valeronitrile and dimethyl sulfoxide were mixed in a volume ratio of 9:1. All reagents used in the process above were purchased from Aldrich Co., and all the reagents were used without additional purification.

**(Manufacturing a dye-sensized solar cell)**

**Example 1**

A porous film having a thickness of $12\mu m$ was prepared by coating a $TiO_2$ paste (PST-18NR, available from JGC C&C, Japan) having an average particle diameter of about 20 nm in a thickness of $12\mu m$, on a first conductive film with a thickness of 2.3 mm that includes fluorine-containing tin oxide (FTO) of a first electrode through a screen printing, and calcining the same for 30 minutes at 500°C to form a resultant. The resultant was maintained at 80°C, immersed in 0.2 mN of an N719 dye solution dissolved in ethanol, and dye adsorption treatment was performed for 24 hours to form a dye-adsorbed porous film. Thereafter, the dye-adsorbed porous film was washed using ethanol, and was dried at room temperature to prepare a first electrode formed with a light absorbing layer. In a second electrode, a secondary conductive film including platinum (Pt) was deposited on a first conductive film including FTO by sputtering for 20 minutes, and holes for injecting an electrolyte were created by using a drill having a diameter of about 0.1 mm. A support including a hot melt film (available from Suryln, Dupont) having a thickness of $60\mu m$ was interposed between the first electrode including the porous film and the second electrode including the holes, and the first electrode and the second electrode were compressed by pressing the electrodes for 15 seconds at 130°C by using a hot press. Thereafter, the electrolyte prepared according to Preparation Example 1 was injected into the holes formed on the second electrode to manufacture a dye-sensitized solar cell.

**Example 2**

A dye-sensitized solar cell was manufactured in the same manner as in Example 1, except for using the electrolyte prepared according to Preparation Example 2, instead of using the electrolyte prepared according to Preparation Example 1.

**Example 3**

A dye-sensitized solar cell was manufactured in the same manner as in Example 1, except for using the electrolyte prepared according to Preparation Example 3, instead of using the electrolyte prepared according to Preparation Example 1.

**Example 4**

A dye-sensitized solar cell was manufactured in the same manner as in Example 1, except for using the electrolyte prepared according to Preparation Example 4, instead of using the electrolyte prepared according to Preparation Example 1.

**Example 5**

A dye-sensitized solar cell was manufactured in the same manner as in Example 1, except for using the electrolyte prepared according to Preparation Example 5, instead of using the electrolyte prepared according to Preparation Example 1.

**Example 6**

A dye-sensitized solar cell was manufactured in the same manner as in Example 1, except for using the electrolyte prepared according to Preparation Example 6, instead of using the electrolyte prepared according to Preparation Example 1.

### Example 7

A dye-sensitized solar cell was manufactured in the same manner as in Example 1, except for using the electrolyte prepared according to Preparation Example 7, instead of using the electrolyte prepared according to Preparation Example 1.

### Example 8

A dye-sensitized solar cell was manufactured in the same manner as in Example 1, except for using the electrolyte prepared according to Preparation Example 8, instead of using the electrolyte prepared according to Preparation Example 1.

### Comparative Example 1

A dye-sensitized solar cell was manufactured in the same manner as in Example 1, except for using the electrolyte prepared according to Comparative Preparation Example 1, instead of using the electrolyte prepared according to Preparation Example 1.

### Comparative Example 2

A dye-sensitized solar cell was manufactured in the same manner as in Example 1, except for using the electrolyte prepared according to Comparative Preparation Example 2, instead of using the electrolyte prepared according to Preparation Example 1.

### Comparative Example 3

A dye-sensitized solar cell was manufactured in the same manner as in Example 1, except for using the electrolyte prepared according to Comparative Preparation Example 3, instead of using the electrolyte prepared according to Preparation Example 1.

### Comparative Example 4

A dye-sensitized solar cell was manufactured in the same manner as in Example 1, except for using the electrolyte prepared according to Comparative Preparation Example 4, instead of using the electrolyte prepared according to Preparation Example 1.

### Comparative Example 5

A dye-sensitized solar cell was manufactured in the same manner as in Example 1, except for using the electrolyte prepared according to Comparative Preparation Example 5, instead of using the electrolyte prepared according to Preparation Example 1.

### Comparative Example 6

A dye-sensitized solar cell was manufactured in the same manner as in Example 1, except for using the electrolyte prepared according to Comparative Preparation Example 6, instead of using the electrolyte prepared according to Preparation Example 1.

### Comparative Example 7

A dye-sensitized solar cell was manufactured in the same manner as in Example 1, except for using the electrolyte prepared according to Comparative Preparation Example 7, instead of using the electrolyte prepared according to Preparation Example 1.

**(Evaluation of the performance of a dye-sensitized solar cell)**

**Evaluation Example 1: Evaluation of initial efficiency**

(1) R1, R2, R3, and series resistance ($R_s$)

An electrochemical electron impedance spectroscopy (EIS) analysis was performed under standard measurement conditions (AM1.5G, 100 mW $cm^{-2}$) on the dye-sensitized solar cells prepared according to Example 3, and Comparative Examples 2 and 4. The results of the electrochemical EIS analysis are shown in Table 1 and FIG. 2.

A series resistance ($R_s$) of the dye-sensitized solar cells of Example 3 and Comparative Examples 2 and 4 was measured by using SI 1260 (available from Solartron).

R1 of Table 1 below represents a resistance between a second electrode and an electrolyte, R2 represents a resistance in a light absorbing layer, and R3 represents a resistance related to ion diffusion in the electrolyte.

Table 1

|  | R1 | R2 | R3 | $R_s$ |
|---|---|---|---|---|
| Example 3 | 9.39 | 12.08 | 5.37 | 30.73 |
| Comparative Example 2 | 25.30 | 11.18 | 10.59 | 50.97 |
| Comparative Example 4 | 15.33 | 12.93 | 9.09 | 41.11 |

Referring to Table 1 and FIG. 2, the values of R1, R3, and $R_s$ of Example 3 were smaller than R1, R3, and $R_s$ of Comparative Example 2, and the values of R1, R2, R3, and $R_s$ of Example 3 were smaller than R1, R2, R3, and $R_s$ of Comparative Example 4.

It may be concluded from this that the internal resistance of the dye-sensitized solar cell manufactured according to Example 3 is smaller than the internal resistance of the dye-sensitized solar cells manufactured according to Comparative Examples 2 and 4, and that the movement of electrons of the electrolyte included in the dye-sensitized solar cell manufactured according to Example 3 is easier than the movement of electrons of the electrolytes included in the dye-sensitized solar cells manufactured according to Comparative Examples 2 and 4.

(2) Evaluation of light conversion efficiency

A voltage and a photocurrent characteristic were evaluated with respect to the dye-sensitized solar cells manufactured according to Examples 1 to 8, and Comparative Examples 2 and 3. The results of the evaluation are shown in Table 2. Measurement conditions were as follows.

An open voltage ($V_{oc}$) and a photocurrent density ($J_{sc}$) were measured by using YSS-200A (available from Yamashita Denso). A light conversion efficiency (Eff) was measured by using a solar simulator (including an Xe lamp [300W] available from Oriel, $AM_{1.5}$ filter, and $SMU_{240}$ available from Keithley), and a fill factor (FF) and the light conversion efficiency (Eff) were calculated by using the conversion efficiency obtained from above and from Formulae 1 and 2 below.

[Formula 1]

$$\text{Fill factor}(\%) = [(J \times V)_{max}/(J_{sc} \times V_{oc})] \times 100$$

[Formula 2]

$$\text{Light conversion efficiency }(\%) = (V_{oc} \times J_{sc} \times FF)/(P_{inc})$$

In Formula 1 above, J is a value of Y-axis in a light conversion efficiency curve, V is a value of X-axis in the light conversion efficiency curve, and $J_{sc}$ and $V_{oc}$ are intercept values of each axis, respectively. In formula 2 above, $P_{inc}$ is 100 mW/$cm^2$ (1 sun).

Table 2

|  | $J_{sc}$(mA/cm$^2$) | $V_{oc}$(V) | FF(%) | Eff(%) |
|---|---|---|---|---|
| Example 1 | 9.839 | 0.691 | 58.9 | 4.00 |
| Example 2 | 9.507 | 0.697 | 62.0 | 4.11 |
| Example 3 | 9.138 | 0.697 | 66.1 | 4.21 |
| Example 4 | 9.741 | 0.690 | 67.1 | 4.51 |
| Example 5 | 9.263 | 0.684 | 70.0 | 4.41 |
| Example 6 | 9.407 | 0.693 | 67.1 | 4.37 |
| Example 7 | 9.600 | 0.695 | 62.1 | 4.13 |
| Example 8 | 9.587 | 0.684 | 62.9 | 4.12 |
| Comparative Example 2 | 8.770 | 0.679 | 58.1 | 3.46 |
| Comparative Example 3 | 10.201 | 0.677 | 55.2 | 3.81 |

Referring to Table 2 above, light conversion efficiencies (Eff) of the dye-sensitized solar cells of Examples 1 to 8 are better than light conversion efficiencies (Eff) of the dye-sensitized solar cells of Comparative Examples 2 and 3.

**Evaluation Example 2**: **Evaluation of normalization efficiency - evaluation of durability**

The dye-sensitized solar cells of Examples 3 and 4, and Comparative Examples 1, 2, 5, and 7 were maintained in the dark for 500 hours at 85°C, and a decrease in efficiency was observed. A measurement of the efficiency was measured by taking out the dye-sensitized solar cell maintained at 85°C from a constant-temperature oven and dropping the temperature to room temperature. The results are shown in FIG. 3, and normalization efficiency was calculated by using Formula 3.

[Formula 3]

$$\text{Normalization efficiency} = [(\text{Measured efficiency value} / \text{initial efficiency value})] \times 100$$

As illustrated in FIG. 3, a decrease in the normalization efficiencies of the dye-sensitized solar cells of Examples 3 and 4 was smaller than a decrease in the normalization efficiencies of the dye-sensitized solar cells of Comparative Examples 1, 2, 5, and 7, after measuring performance for 500 hours.

In view of the above and according to one embodiment, the electrolyte for a dye-sensitized solar cell includes a redox derivative; a solvent mixture in which a nitrile-based compound having a $C_3$-$C_{10}$ linear carbon chain and a sulfoxide-based compound are mixed in a volume ratio of about 1:9 to about 9:1, and/or another solvent having desired boiling point. Here, the electrolyte has desired viscosity and boiling point, thereby improving durability and performance such as energy conversion efficiency and light conversion efficiency of the dye-sensitized solar cell including the electrolyte.

It should be understood that the exemplary embodiments described therein should be considered in a descriptive sense only and not for purposes of limitation. Descriptions of features or aspects within each embodiment should typically be considered as available for other similar features or aspects in other embodiments, and equivalents thereof.

**Claims**

1.   An electrolyte for a dye-sensitized solar cell comprising:

a redox derivative; and
a solvent mixture in which a nitrile-based compound having a $C_3$-$C_{10}$ linear carbon chain and a sulfoxide-based compound are mixed in a volume ratio of about 1:9 to about 9:1.

2. The electrolyte for a dye-sensitized solar cell of claim 1, wherein the solvent mixture comprises a nitrile-based compound having a $C_3$-$C_{10}$ linear carbon chain and a sulfoxide-based compound mixed in a volume ratio of about 9:1 to about 5:5.

3. The electrolyte for a dye-sensitized solar cell of either claim 1 or claim 2, wherein the nitrile-based compound is one selected from the group consisting of butyronitrile, valeronitrile, hexanenitrile, and heptanenitrile.

4. The electrolyte for a dye-sensitized solar cell of any one of the preceding claims, wherein the sulfoxide-based compound is one selected from the group consisting of dimethyl sulfoxide, methyl sulfoxide, and ethyl methyl sulfoxide.

5. The electrolyte for a dye-sensitized solar cell of any one of the preceding claims, wherein a viscosity of the solvent mixture at 25°C is about 0.80 cP to about 1.50 cP.

6. The electrolyte for a dye-sensitized solar cell of any one of the preceding claims, wherein a dielectric constant of the solvent mixture at 25°C is about 15 to about 35.

7. The electrolyte for a dye-sensitized solar cell of any one of the preceding claims, wherein the solvent mixture further comprises an auxiliary solvent having a boiling point of 95°C or greater.

8. The electrolyte for a dye-sensitized solar cell of claim 7, wherein the auxiliary solvent comprises at least one of an amide-based compound, a nitrile-based compound having an unsubstituted $C_1$-$C_3$ linear carbon chain, and a nitrogen-containing heterocyclic compound having a 6-membered ring structure.

9. The electrolyte for a dye-sensitized solar cell of claim 7, wherein the auxiliary solvent comprises at least one selected from the group consisting of formamide, dimethyl acetamide, dimethylformamide, N-methylformamide, diethyl formamide, N, N-dimethyl ethanamide, acetonitrile, propionitrile, pyridine, and 4-tert-butylpyridine (4-TBP).

10. The electrolyte for a dye-sensitized solar cell of any one of claims 7 to 9, wherein an amount of the auxiliary solvent is less than 10 volume parts based on a total of 100 volume parts of the electrolyte.

11. The electrolyte for a dye-sensitized solar cell of any one of the preceding claims, wherein the redox derivative provides an $I^-/I_3^-$ redox pair.

12. The electrolyte for a dye-sensitized solar cell of claim 11, wherein the $I^-/I_3^-$ redox pair are produced from iodide salts and/or iodide compounds selected from the group consisting of lithium iodide, sodium iodide, potassium iodide, magnesium iodide, copper iodide, silicon iodide, manganese iodide, barium iodide, molybdenum iodide, calcium iodide, iron iodide, cesium iodide, zinc iodide, mercury iodide, ammonium iodide, methyl iodide, methylene iodide, ethyl iodide, ethylene iodide, isopropyl iodide, isobutyl iodide, benzyl iodide, benzoyl iodide, allyl iodide, imidazolium iodide, 1-propyl-3-methyl imidazolium iodide, and 1-butyl-3-methyl imidazolium iodide.

13. A dye-sensitized solar cell comprising:

   a first electrode;
   a light absorbing layer on a side of the first electrode;
   a second electrode facing the side of the first electrode where the light absorbing layer is on; and
   an electrolyte as defined in any one of the preceding claims interposed between the first electrode and the second electrode.

14. The dye-sensitized solar cell of claim 13, wherein the light absorbing layer comprises semiconductor particles and dye molecules.

15. Use of an electrolyte as defined in any one of claims 1 to 12 in a dye-sensitized solar cell.

FIG. 1

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020130019371